# EUROPÄISCHE PATENTSCHRIFT

(11) **EP 0 382 887 B1**
(45) Veröffentlichungstag und Bekanntmachung des Hinweises auf die Patenterteilung: **11.08.1993**
(21) Anmeldenummer: 89114604.5
(22) Anmeldetag: 08.08.1989
(51) Int. Cl.: H02P 8/00

(54) **Bewegungsaufnehmer für einen Schrittschaltmotor**
Stepper motor motion sensor
Capteur de mouvement pour un moteur pas à pas

(30) Priorität: 30.06.1989 DE 3921462; 14.02.1989 DE 3904332
(43) Veröffentlichungstag der Anmeldung: 22.08.1990
(73) Patentinhaber: VDO Adolf Schindling AG, D-60487 Frankfurt (DE)
(72) Erfinder: Kronenberg, Klaus, D-6231 Schwalbach/Ts. (DE)
(74) Vertreter: Klein, Thomas, Dipl.-Ing. (FH)

(56) Entgegenhaltungen:
- EP-A- 0 046 722
- DE-A- 3 535 666
- FR-A- 2 576 469
- US-A- 4 449 086

## Beschreibung

Die Erfindung bezieht sich auf ein Verfahren zum Betreiben eines Anzeigeinstruments, bei dem ein Zeiger oder dergleichen von einem Schrittmotor, der mehrere Wicklungen besitzt und von einem Mikroprozessor angesteuert wird, über eine Skala geführt wird, die am Skalenanfang (oder -ende) einen mechanischen Anschlag für den Zeiger aufweist und bei dem eine durch die Bewegung des Schrittmotors induzierte Spannung in einer jeweils nicht zum Antrieb benötigten Wicklung gemessen wird.

Ein solches Verfahren ist aus FR-A- 2 567 469 bekannt.

Beim Betrieb eines Schrittmotors, insbesondere mit einem nachgeschalteten Getriebe, ist häufig eine Information über die jeweilige Position des Schrittmotors bzw. Getriebsabtriebs erforderlich. Dazu sind Sensoren, wie beispielsweise Näherungsschalter, mechanische Endschalter und Lichtschranken bekannt. Diese Sensoren erfordern jedoch einen zusätzlichen Aufwand an Teilen und Montagezeiten, was sich nachteilig auf die Kosten auswirkt. Außerdem bedeuten sie ein erhöhtes Volumen der jeweiligen Baueinheit.

Insbesondere werden derartige Sensoren dazu benötigt, nach dem Einschalten ein Steuergerät für einen Schrittmotor derart zu initialisieren, daß ein vorgegebener Bezug zwischen den im Steuergerät vorhandenen Informationen und der tatsächlichen Stellung des Schrittmotors bzw. des Getriebeabtriebs wiederhergestellt wird.

Aufgabe der vorliegenden Erfindung ist es, ein Verfahren der eingangs genannten Art anzugeben, bei dem die Synchronisation zwischen Zeigerstellung und Speicherinhalt des Steuergeräts ohne zusätzliche Sensoren herstellbar ist.

Das erfindungsgemäße Verfahren ist dadurch gekennzeichnet, daß der Schrittmotor nach dem Einschalten so angesteuert wird, daß sich der Zeiger in Richtung auf den Anschlag dreht und daß das Ausbleiben der induzierten Spannung als Zeichen für das Anliegen des Zeigers am Anschlag ausgewertet und der die Position des Schrittmotors repräsentierende Inhalt eines Speichers im Mikroprozessor auf einen vorgegebenen Wert gesetzt und danach der Normalbetrieb des Anzeigeinstruments aufgenommen wird.

Bei der Bewegung des Rotors wird innerhalb eines Schrittes eine exponentiell abklingende Schwingung in der jeweils nicht zum Antrieb benötigten Wicklung induziert, welche von Schritt zur Schritt eine andere Polarität einnimmt. Wird jedoch das erste Induktionsspannungsmaximum mit einer vorgegebenen Polarität ausgewertet, so führt dieses zu ungleichen Ergebnissen von Schritt zu Schritt. Um dieses zu vermeiden, ist gemäß einer Weiterbildung des erfindungsgemäßen Verfahrens vorgesehen, daß die in der jeweils nicht zum Antrieb benötigten Wicklung induzierte Spannung von Schritt zu Schritt mit wechselnder Polarität ausgewertet wird.

Zur Durchführung des erfindungsgemäßen Verfahrens ist eine Schaltungsanordnung geeignet, bei der die Wicklungen des Schrittmotors über Umschalteinrichtungen wahlweise mit Ausgängen von Treiberstufen oder mit dem Eingang eines Detektorelements verbindbar sind und bei der die Umschalteinrichtungen und die Treiberstufen von einer Steuerlogik steuerbar sind.

Dabei kann man vorsehen, daß jeweils für eine Wicklung eine Umschalteinrichtung mit zwei parallel gesteuerten Umschaltern vorgesehen ist, von denen ein Umschalter einen ersten Anschluß der Wicklung entweder mit dem Ausgang einer ersten Treiberstufe oder mit dem Eingang des Detektorelements und ein zweiter Umschalter einen zweiten Anschluß der Wicklung entweder mit dem Ausgang einer zweiten Treiberstufe oder mit Massepotential verbindet.

Zur Vermeidung der mit der wechselnden Polarität der induzierten Spannung verbundenen Nachteile kann man vorsehen, daß die Umschalteinrichtungen jeweils drei Schaltstellungen aufweisen, daß in einer ersten Schaltstellung die jeweilige Wicklung des Schrittmotors mit Ausgängen der Treiberstufen verbunden ist und daß in der zweiten Schaltstellung ein erster Anschluß der jeweiligen Wicklung mit Masse und ein zweiter Anschluß der Wicklung mit den Eingang des Detektorelements verbunden ist und daß in der dritten Schaltstellung der erste Anschluß der Wicklung an den Eingang des Detektorelements und der zweite Anschluß der Wicklung an Masse angeschlossen ist.

Das erfindungsgemäße Verfahren läßt sich mit verschiedenen Schaltungsanordnungen durchführen. Zwei davon sind schematisch in den Figuren 1 bis 4 dargestellt und werden nachfolgend beschrieben.

Es zeigen:
- Fig. 1: ein teilweise als Blockschaltbild ausgeführtes Schaltbild eines ersten Ausführungsbeispiels zur Durchführung des erfingdungsgemäßen Verfahrens,
- Fig. 2: ein Flußdiagramm eines zur Durchführung des erfingdungsgemäßen Verfahrens vorgesehenen Computerprogramms,
- Fig. 3: ein zweites Ausführungsbeispiel zur Durchführung des erfingdungsgemäßen Verfahrens und
- Fig. 4: Spannungszeitdiagramme der induzierten Spannung zur Erläuterung des zweiten Ausführungsbeispiels zur Durchführung des erfingdungsgemäßen Verfahrens.

Gleiche Teile sind in den Figuren mit gleichen Bezugszeichen versehen.

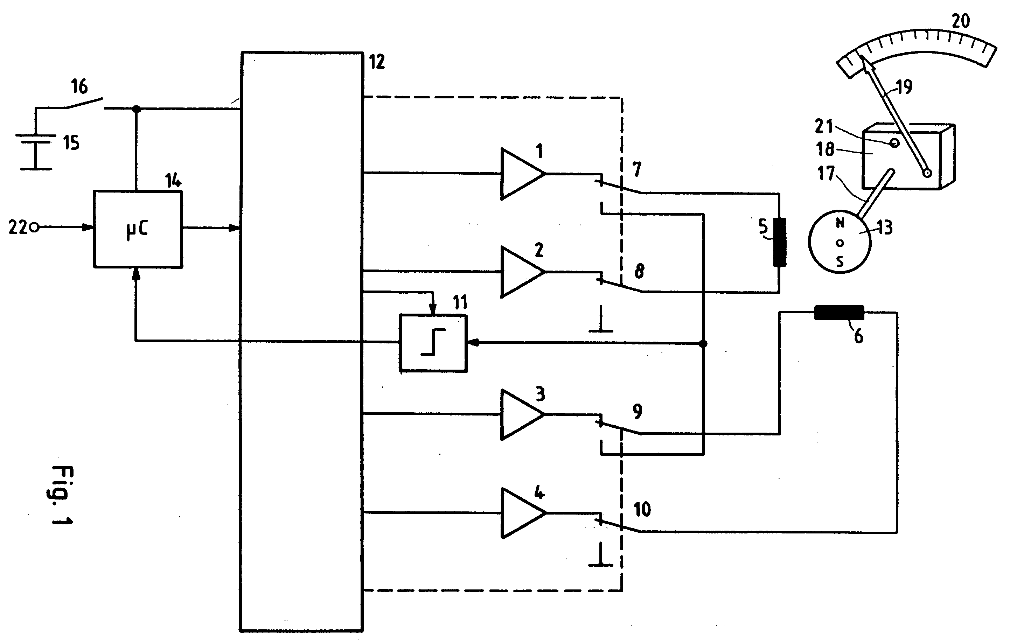

Bei dem in Fig. 1 dargestellten Ausführungsbeispiel zur Durchführung des erfingdungsgemäßen Verfahrens sind vier Treiberstufen 1, 2, 3, 4 vorgesehen, mit welchen die Wicklungen 5, 6 eines Schrittmotors mit Spannung beaufschlagt werden können. Der Schrittmotor umfaßt einen permanentmagnetischen Rotor 13, der in an sich bekannter Weise durch wechselnde Magnetfelder in den Wicklungen 5, 6 angetrieben wird. Dabei wird jeweils eine der Wicklungen 5, 6 mit einem Strom in einer derartigen Richtung beaufschlagt, daß der in Bewegungsrichtung liegende Magnetpol N, S angezogen wird, während die andere Wicklung solange stromlos bleibt.

Zur Erzeugung entsprechender Impulse, die über die Treiberstufen 1 bis 4 den Wicklungen 5, 6 zugeführt werden, dient eine Steuerlogik 12. Da die Erzeugung von Steuerspannungen für Schrittmotoren an sich bekannt ist, braucht zur Erläuterung der Erfindung auf Einzelheiten der Steuerlogik 12 nicht eingegangen zu werden. Ein Eingang der Steuerlogik 12 ist mit dem Ausgang eines Mikrocomputers 14 verbunden. Ferner werden der Mikrocomputer 14, die Steuerlogik 12, das Detektorelement 11 und die Treiberstufen 1 bis 4 mit einer Betriebsspannung versorgt, was in Fig. 1 schematisch durch eine Spannungsquelle 15 und einen Schalter 16 dargestellt ist.

Bei dem Ausführungsbeispiel dient der Schrittmotor zum Antrieb eines Anzeigeinstruments. Dazu ist die Abtriebswelle 17 des Schrittmotors über ein Getriebe 18 mit einem Zeiger 19 verbunden, der eine Skala 20 bestreicht. In der Nähe des Nullpunktes der Skala 20 ist ein Anschlag 21 für den Zeiger 19 vorgesehen.

Zur Durchführung des erfindungsgemäßen Verfahrens sind zwischen die Ausgänge der Treiberstufen 1 bis 4 und die Anschlüsse der Wicklungen 5 und 6 Umschalter 7, 8, 9, 10 eingefügt, welche von der Steuerlogik 12 steuerbar sind. Die Umschalter können in an sich bekannter Weise von geeigneten Halbleiterschaltern gebildet werden. Durch die Umschalter 7, 8, 9, 10 können die Wicklungen entweder mit den Ausgängen der Treiberstufen 1 bis 4 oder mit dem Eingang einer Schwellwertschaltung 11 verbunden werden. Und zwar wird jeweils die zu bestromende Wicklung mit den Ausgängen der ihr zugeordneten Treiberstufen verbunden, während ein Anschluß der nicht zu bestromenden Wicklung mit Massepotential und der andere Anschluß dieser Wicklung mit dem Eingang der Schwellwertschaltung verbunden ist.

Der Ausgang der Schwellwertschaltung 11 ist an einen Eingang des Mikrocomputers 14 angeschlossen. Vorzugsweise wird hierzu ein Eingang IR zur Programmunterbrechung (Interrupt) verwendet, so daß die Auswertung der Ausgangsspannung der Schwellwertschaltung sofort vorgenommen werden kann. Da eine Auswertung der induzierten Spannung nicht zu jedem Zeitpunkt sinnvoll ist, wird die Schwellwertschaltung 11 von der Steuerlogik 12 jeweils zu einem geeigneten Zeitpunkt aktiviert.

Bei dem in Fig. 1 dargestellten Ausführungsbeispiel wird mit Hilfe des Mikrocomputers 14 eine bei 22 zugeführte anzuzeigende Größe in eine Anzahl von Schritten umgewandelt, welche der Schrittmotor dann vollführt, um die Größe entsprechend zur Anzeige zu bringen. Wird durch Auftrennen des Schalters 16 die Betriebsspannung abgeschaltet, so bleibt der Schrittmotor und damit der Zeiger 19 in der jeweils erreichten Stellung stehen. Beim Wiedereinschalten der Anordnung besteht somit kein Bezug mehr zwischen einer vom Mikrocomputer 14 errechneten Anzahl von Schritten und der tatsächlichen Stellung des Zeigers 19. Deshalb erfolgt nach dem Einschalten eine sogenannte Initialisierung dadurch, daß der Schrittmotor derart bestromt wird, daß der Zeiger 19 gegen den Anschlag 21 läuft. Während dieser Zeit wird die induzierte Spannung bzw. das Ausgangssignal der Schwellwertschaltung 11 ausgewertet, bis keine Spannung induziert wird. Dieses ist ein Zeichen dafür, daß der Schrittmotor stehengeblieben ist bzw. daß der Zeiger 19 gegen den Anschlag 21 gefahren ist. Ein Speicher, der die jeweilige Stellung des Zeigers 19 beinhaltet, wird nunmehr auf 0 bzw. einen anderen geeigneten vorgegebenen Wert gesetzt. Danach ist der Mikrocomputer 14 bereit, eine bei 22 zugeführte Größe in eine entsprechende Zahl von Schritten umzurechnen und über die Steuerlogik 12 dem Schrittmotor die entsprechende Zahl von Impulsen zuzuführen.

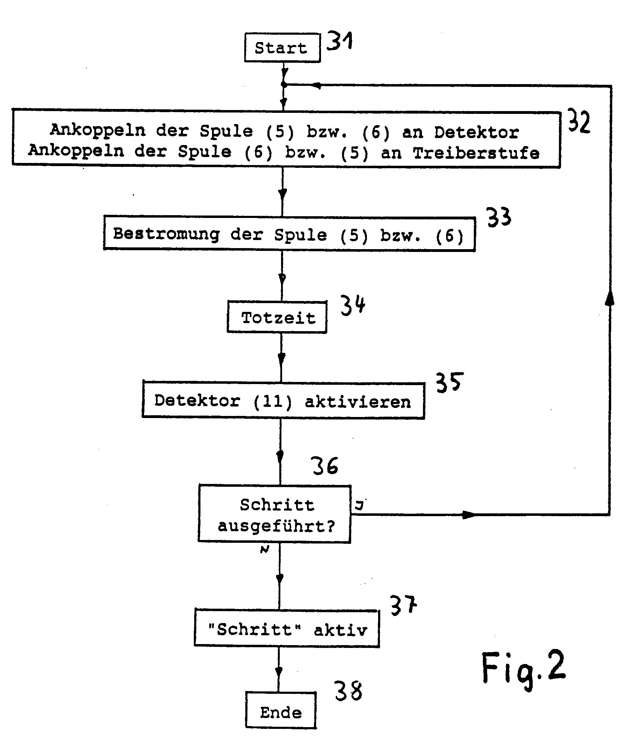

Fig. 2 zeigt ein Flußdiagramm desjenigen Teils des Mikrocomputerprogramms, das zur Durchführung des erfindungsgemäßen Verfahrens geeignet ist. Nach einem Start bei 31 werden im Programmteil 32 die Umschalter 7 bis 10 derart gesteuert, daß die Wicklung 5 bzw. 6 an das Detektorelement und die Wicklung 6 bzw. 5 an die Treiberstufen angeschlossen wird. Danach erfolgt im Programmteil 33 die Bestromung der Wicklung 5 bzw. 6. Nach einer Totzeit 34 wird bei 35 das Detektorelement 11 aktiviert, wodurch ein der induzierten Spannung entsprechendes Signal dem Mikrocomputer zugeführt wird.

Bei 36 wird das Programm in Abhängigkeit davon aktiviert, ob ein Schritt ausgeführt wurde. Ist dieses der Fall, so wird der Schrittmotor für den nächsten Schritt über die Programmteile 32 und 33 angesteuert. Nach der Totzeit 34 wird bei 35 erneut durch Aktivierung des Detektorelements 11 abgefragt, ob ein Schritt ausgeführt wurde. Diese Schleife wird solange durchlaufen, bis der Zeiger 19 am Anschlag 20 anschlägt. Dann wird festgestellt, daß keine induzierte Spannung mehr vorliegt, daß also kein Schritt mehr ausgeführt wurde. Das Programm geht daher von der Verzweigung 36 zu einer Ausgabe "Schritt" aktiv, welche besagt, daß nunmehr eine gezielte Bewegung des Zeigers möglich ist. Bei 38 wird das Programm beendet.

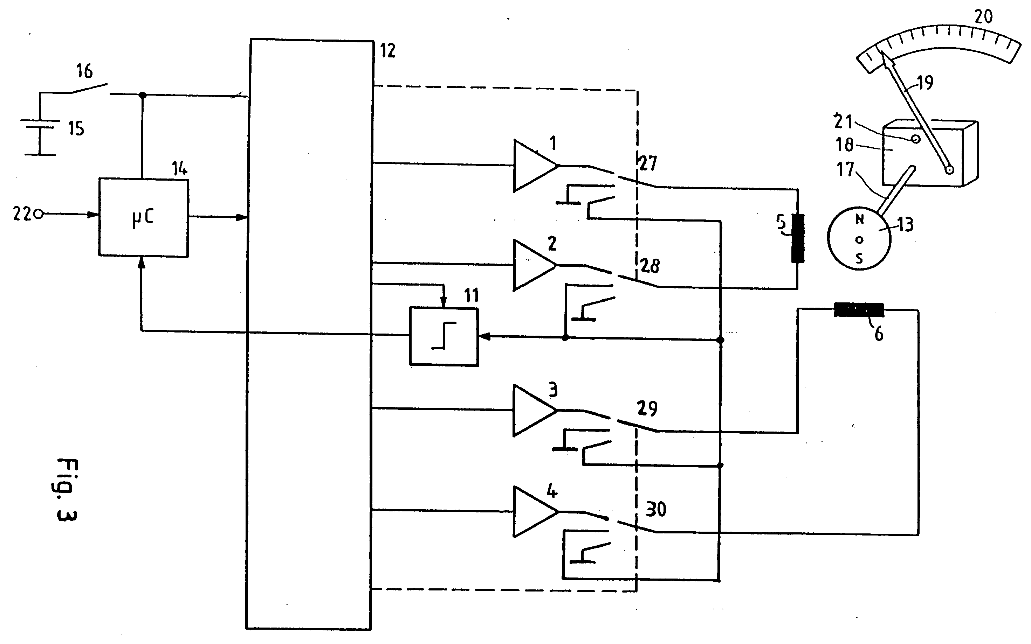

Das Ausführungsbeispiel nach Fig. 3 unterscheidet sich von dem ersten Ausführungsbeispiel dadurch, daß die Umschalter 27, 28, 29, 30 mit jeweils drei Schaltstellungen versehen sind. In der oberen Stellung ist die jeweilige Wicklung wie bei dem ersten Ausführungsbeispiel mit den Ausgängen der Treiberstufen 1, 2; 3, 4 verbunden. In der zweiten, mittleren Stellung ist jeweils ein Anschluß der Wicklung 5, 6 mit Massepotential und der andere Anschluß mit dem Eingang des Detektorelementes 11 verbunden. In der dritten Stellung ist die Wicklung gegenüber der zweiten Stellung umgepolt.

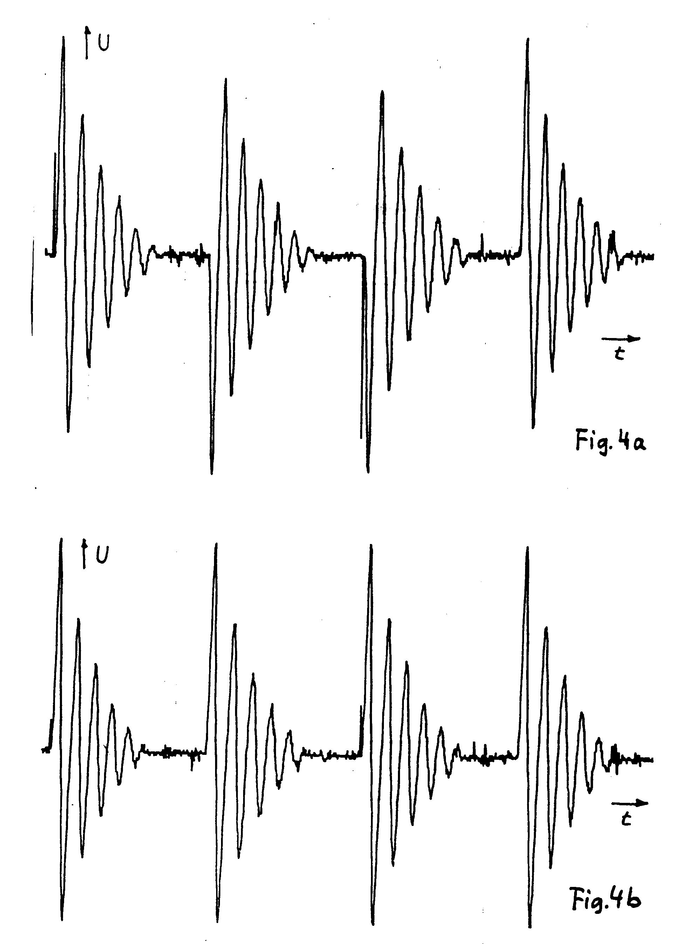

Von der Steuerlogik 12 werden die Umschalter 27 bis 30 derart gesteuert, daß abwechselnd die Wicklungen 5, 6 bestromt werden und die jeweils nicht bestromte Wicklung schrittweise abwechselnd mit verschiedener Polung mit dem Eingang des Detektorelementes 11 verbunden wird. Fig. 4a zeigt den Verlauf der Spannung am Eingang des Detektorelementes 11 während des Ablaufs von vier Schritten bei der Schaltungsanordnung nach Fig. 1. Dabei entstehen vier gedämpfte Schwingungzüge - zwei von jeweils einer der Wicklungen 5, 6. Bei jeder zweiten nicht bestromten Phase einer Wicklung kehrt sich die Polarität der gedämpften Schwingung um. Damit ändert sich auch der Wert des ersten Maximums bei gegebenem Vorzeichen. Da dieser durch das Detektorelement 11 ausgewertet wird, ergeben sich bei der Schaltungsanordnung nach Fig. 1 Schwankungen zwischen den einzelnen Schritten.

Durch die gleichrichtende Wirkung der Umschalter 27 bis 30 bei der Schaltungsanordnung nach Fig. 3 wird das jeweils erste Maximum von Schritt zu Schritt gleich groß. Dieses ist aus Fig. 4b ersichtlich.

## Patentansprüche

1. Verfahren zum Betreiben eines Anzeigeinstruments, bei dem ein Zeiger oder dergleichen von einem Schrittmotor, der mehrere Wicklungen besitzt und von einem Mikroprozessor angesteuert wird, über eine Skala geführt wird, die am Skalenanfang (oder -ende) einen mechanischen Anschlag für den Zeiger aufweist und bei dem eine durch die Bewegung des Schrittmotors induzierte Spannung in einer jeweils nicht zum Antrieb benötigten Wicklung gemessen wird, dadurch gekennzeichnet, daß der Schrittmotor nach dem Einschalten so angesteuert wird, daß sich der Zeiger in Richtung auf den Anschlag dreht und daß das Ausbleiben der induzierten Spannung als Zeichen für das Anliegen des Zeigers am Anschlag ausgewertet und der die Position des Schrittmotors repräsentierende Inhalt eines Speichers im Mikroprozessor auf einen vorgegebenen Wert gesetzt und danach der Normalbetrieb des Anzeigeinstruments aufgenommen wird.

2. Verfahren nach Anspruch 1, dadurch gekennzeichnet, daß die in der jeweils nicht zum Antrieb benötigten Wicklung induzierte Spannung von Schritt zu Schritt abwechselnd mit verschiedener Polarität ausgewertet wird.

## Claims

1. Method for operating an indicator instrument, wherein a pointer or the like is guided by a stepping motor, which has a plurality of windings and is operated by a microprocessor, over a scale which has at the beginning (or end) of the scale a mechanical abutment for the pointer, and wherein a voltage induced by the movement of the stepping motor in a respective winding not required for driving is measured, characterised in that after the switch-on the stepping motor is so operated that the pointer rotates in the direction towards the abutment, and that the absence of the induced voltage is interpreted as a sign that the pointer is against the abutment, and that content of a memory in the microprocessor which represents the position of the stepping motor is set to a predetermined value and thereafter the normal working of the indicator instrument is started.

2. Method according to claim 1, characterised in that the voltage induced in the respective winding not needed for driving is evaluated with different polarity alternately from step to step.

## Revendications

1. Procédé d'actionnement d'un instrument d'affichage, selon lequel une aiguille ou pièce similaire est guidée, par un moteur pas à pas possédant plusieurs enroulements et activé par un microprocesseur, sur une échelle graduée qui présente, au début (ou à la fin) de la graduation, une butée mécanique destinée à l'aiguille ; et selon lequel une tension, induite par le mouvement du moteur pas à pas, est mesurée dans un enroulement considéré ne prenant pas part à l'entraînement, caractérisé par le fait que le moteur pas à pas est activé, après l'enclenchement, de telle sorte que l'aiguille tourne en direction de la butée ; et par le fait que l'absence de la tension induite est interprétée comme signifiant que l'aiguille est appliquée contre la butée, et le contenu d'une mémoire dans le microprocesseur, représentatif de la position du moteur pas à pas, est amené à une valeur préétablie, après quoi le fonctionnement normal de l'instrument d'affichage est capté.

2. Procédé selon la revendication 1, caractérisé par le fait que la tension, induite dans l'enroulement considéré ne prenant pas part à l'entraînement, est interprétée en alternance d'un pas à l'autre avec une polarité différente.
